# EUROPÄISCHE PATENTSCHRIFT

(11) **EP 2 989 385 B1**
(45) Veröffentlichungstag und Bekanntmachung des Hinweises auf die Patenterteilung: **08.03.2017**
(21) Anmeldenummer: 14718053.3
(22) Anmeldetag: 15.04.2014
(51) Int. Cl.: F21V 25/12, F21V 29/00, F21V 31/00, F21V 5/00, F21V 17/16, F21S 2/00, F21Y 105/00

(54) **EXPLOSIONSGESCHÜTZTE ANORDNUNG ELEKTRISCHER UND/ODER ELEKTRONISCHER BAUELEMENTE**
EXPLOSION-PROTECTED ARRANGEMENT OF ELECTRICAL AND/OR ELECTRONIC COMPONENTS
DISPOSITIF ANTIDÉFLAGRANT DE COMPOSANTS ÉLECTRIQUES ET/OU ÉLECTRONIQUES

(30) Priorität: 26.04.2013 DE 102013104240
(43) Veröffentlichungstag der Anmeldung: 02.03.2016
(73) Patentinhaber: R. Stahl Schaltgeräte GmbH, 74638 Waldenburg (DE)
(72) Erfinder: RÜCKGAUER, Johannes, 74653 Künzelsau-Nagelsberg (DE)
(74) Vertreter: Rüger, Barthelt & Abel
(86) Internationale Anmeldenummer: PCT/EP2014/057632
(87) Internationale Veröffentlichungsnummer: WO 2014/173734

(56) Entgegenhaltungen:
- DE-A1-102010 018 784
- KR-B1- 101 201 153
- US-A1- 2011 157 891
- US-A1- 2013 088 871

## Beschreibung

Die Erfindung betrifft eine explosionsgeschützte Anordnung, die mehrere elektrische und/oder elektronische Bauelemente und insbesondere Licht empfangende und/oder Licht abstrahlende Bauelemente aufweist. Als Bauelemente können auch Halbleiterbauelemente vorgesehen sein. Beispielsweise können die Bauelemente Halbleiterleuchtmittel wie Leuchtdioden oder Lumineszenzdioden aufweisen.

Als ein Bauelement ist eine separat handhabbare Baueinheit mit einem gemeinsamen Gehäuse und am Gehäuse vorhandenen elektrischen Anschlüssen zu verstehen. Ein integrierter Schaltkreis mit Anschlusspins an einem gemeinsamen Gehäuse ist demnach beispielsweise ein einziges Bauelement, auch wenn er im Gehäuse eine Vielzahl von Transistoren aufweist.

Solche Bauelemente sind auf einem Träger, beispielsweise einer Leiterplatte oder einem Kühlkörper angeordnet und über Leiterbahnen, Bonddrähte oder dergleichen elektrisch kontaktiert.

In explosionsgefährdeten Bereichen müssen solche Anordnungen explosionsgeschützt ausgeführt werden. Hierzu sind verschiedene Möglichkeiten bekannt. Beispielsweise wird in GB 24 58 345 A vorgeschlagen, die Leuchtdioden sowie deren Träger in einem abgedichteten Gehäuse anzuordnen.

DE 10 2010 018 784 A1 schlägt allgemein vor, ein druckfest gekapseltes Teilgehäuse an einer Leiterplatte anzuordnen, so dass die auf der Leiterplatte angeordneten elektrischen Bauelemente innerhalb des druckfest gekapselten Teilgehäuses angeordnet sind. Die Leiterplatte kann dabei Bestandteil des explosionsgeschützten Gehäuses sein.

Eine weitere Lösung ist aus DE 10 2009 005 547 A1 sowie US 2007/0194712 A1 bekannt. Dort wird vorgeschlagen, Leuchtdioden einzeln zu kapseln. Eine haubenförmige Abdeckung wird auf dem Träger angeordnet und ringsum dicht mit dem Träger verbunden. Die Abdeckung stellt somit einen gekapselten Aufnahmeraum für jeweils eine Leuchtdiode zur Verfügung. Es ist allerdings sehr aufwendig, alle Leuchtdioden einzeln zu kapseln.

KR 101 201 153 B1 zeigt eine explosionsgeschützte Leuchte.

Ausgehend von dem Stand der Technik kann es daher als Aufgabe der vorliegenden Erfindung angesehen werden, eine explosionsgeschützte Anordnung elektrischer und/oder elektronischer Bauelemente zu schaffen, die sich einfach montieren und handhaben lässt.

Diese Aufgabe wird durch eine explosionsgeschützte Anordnung mit den Merkmalen des Patentanspruches 1 gelöst.

Gemäß der vorliegenden Erfindung weist die explosionsgeschützte Anordnung wenigstens einen Träger mit jeweils einer Trägerfläche auf, auf der mehrere elektrische und/oder elektronische Bauelemente, wie etwa Licht empfangende oder Licht abstrahlende Bauelemente mit Abstand zueinander angeordnet sind. Ferner ist wenigstens ein Abdeckkörper vorhanden. Der Abdeckkörper kann - wenn Licht empfangende oder Licht abstrahlende Bauelemente vorhanden sind - zumindest teilweise aus Material hergestellt sein, das für die Lichtwellenlänge des von den Bauelementen abgestrahlten oder zu empfangenden Lichts durchlässig ist. Dabei kann der wenigstens eine Abdeckkörper insbesondere vollständig aus für die Lichtwellenlänge durchlässigem Material ohne Naht- und Fügestellen einstückig hergestellt sein, beispielsweise durch Gießen oder Spritzgießen. Der Abdeckkörper besteht vorzugsweise aus Kunststoff.

Die explosionsgeschützte Anordnung weist außerdem eine Verbindungseinrichtung auf. Die Verbindungseinrichtung dient dazu, vorzugsweise werkzeuglos, eine kraftschlüssige und/oder formschlüssige Verbindung zwischen dem wenigstens einen Abdeckkörper und dem wenigstens einen Träger herzustellen. Beispielsweise kann durch die Verbindungseinrichtung eine Rastverbindung und/oder Klemmverbindung zwischen dem wenigstens einen Abdeckkörper und dem wenigstens einen Träger hergestellt werden. Die durch die Verbindungseinrichtung hergestellte Verbindung ist insbesondere zerstörungsfrei lösbar. Optional kann durch eine Klebefuge auch eine stoffschlüssige Verbindung zwischen dem wenigstens einem Abdeckkörper und dem wenigstens einen Träger hergestellt werden.

Der wenigstens eine Abdeckkörper weist mehrere Abdeckkammern für die Bauelemente auf. Vorzugsweise sind in jeder Aufnahmekammer nur maximal 10 und weiter vorzugsweise nur maximal 5 Bauelemente angeordnet. Bei einem bevorzugten Ausführungsbeispiel ist für jedes Bauelement eine separate Aufnahmekammer vorhanden. Die Anzahl der Aufnahmekammern kann dabei der Anzahl der abzudeckenden elektrischen und/oder elektronischen Bauelemente auf der Trägerfläche entsprechen. Es ist aber auch möglich, Bauelemente, von denen keine Explosionsgefahr ausgeht, beispielsweise eigensichere Bauelemente, auch außerhalb einer Aufnahmekammer auf dem Träger anzuordnen oder einzelne Bauelemente außerhalb der Aufnahmekammern des Abdeckkörpers separat durch ein anderes Mittel zu schützen, beispielsweise durch einen Verguss.

Jede Aufnahmekammer ist an fünf Seiten durch den Abdeckkörper vollständig geschlossen und hat lediglich auf der der Trägerfläche zugewandten Seite eine Öffnung. Somit kann der Abdeckkörper zum Umschließen der Bauelemente einfach auf die Trägerfläche aufgesetzt werden. Dabei wird vorzugsweise über die Verbindungseinrichtung die kraftschlüssige und/oder formschlüssige Verbindung zum zugeordneten Träger hergestellt.

Um jede Öffnung ist am Abdeckkörper ein ringsumlaufender Steg mit einer Stegfläche vorhanden. Die Stegfläche bzw. alle Stegflächen des Abdeckkörpers sind vorzugsweise eben und verlaufen in einer gemeinsamen Ebene. Bei hergestellter Verbindung zwischen dem wenigstens einem Abdeckkörper und dem wenigstens einen Träger bilden die Stegflächen mit einem jeweils zugeordneten Bereich der Trägerfläche einen zünddurchschlagsicheren Spalt. Über die Verbindungseinrichtung wird der wenigstens eine Abdeckkörper am wenigstens einen Träger gesichert und die Zünddurchschlagsicherheit des Spalts gewährleistet.

Erfindungsgemäß besteht die Anordnung lediglich aus wenigen Komponenten: den elektrischen und/oder elektronischen Bauelementen, die auf dem wenigstens einen Träger angeordnet sind, dem wenigstens einen Abdeckkörper sowie der Verbindungseinrichtung, die an dem wenigstens einen Träger und/oder an dem wenigstens einen Abdeckkörper angeordnet ist. Die Anordnung lässt sich sehr einfach explosionsgeschützt montieren. Nach dem Aufbringen der Bauelemente auf dem Träger und deren elektrischer Kontaktierung wird einfach der Abdeckkörper auf die Trägerfläche aufgesetzt und über die vorhandene Verbindungseinrichtung gehalten. Da die einzelnen Aufnahmekammern lediglich ein geringes Volumen aufweisen, ist der sich bei einer Explosion innerhalb einer Aufnahmekammer entwickelnde Druck sehr klein. Deswegen kann die gesamte Anordnung in einer entsprechend leichten Bauweise ausgeführt werden. Durch die Verwendung mehrerer Abdeckkörper und/oder mehrerer Träger kann die Anordnung außerdem sehr einfach modulartig aufgebaut werden, so dass sich auch große Längen und/oder Breiten für eine explosionsgeschützte Anordnung, z.B. eine Leuchte, erreichen lassen.

Das Kammervolumen einer Aufnahmekammer ist insbesondere maximal 1,3- bis 1,5-mal größer als das Volumen des oder der in der Aufnahmekammer aufgenommenen Bauelements bzw. Bauelemente. Jede Aufnahmekammer hat insbesondere ein maximales Kammervolumen von 1 cm³. Bei hergestellter Verbindung ist daher das in der Aufnahmekammer verbleibende Luftvolumen nur sehr gering. Die Aufnahmekammern können, müssen aber nicht gegenüber der Umgebung abgedichtet sein. Die Ausbildung des zünddurchschlagsicheren Spalts zwischen den Stegflächen und der Trägerfläche um jede Aufnahmekammer herum reicht aus. Die minimale Breite des Steges bzw. einer Stegfläche kann bei einem bevorzugten Ausführungsbeispiel 5 bis 10 mm betragen.

Bei einer bevorzugten Ausführungsform wird die Breite des Steges abhängig vom Gesamtvolumen der Aufnahmekammer und/oder vom verbleibenden Restvolumen zwischen dem Bauelement und der zugeordneten Aufnahmekammer vorgegeben. Dadurch kann zwischen den einzelnen Aufnahmekammern sowie zur Umgebung hin jeweils ein zünddurchschlagsicherer Spalt gebildet werden, der an die Größe der Aufnahmekammer angepasst und möglichst klein ist, um die Gesamtgröße der Anordnung möglichst klein zu halten.

Als Träger für die elektrischen und/oder elektronischen Bauelemente kann beispielsweise eine Leiterplatte verwendet werden. Alternativ hierzu ist es auch möglich, dass als Träger ein Kühlkörper verwendet wird. Auch eine Kombination von Leiterplatte mit Kühlkörper kann als Träger dienen. Vorzugsweise besteht der Träger aus Metall, beispielsweise Aluminium, oder einem anderen gut wärmeleitenden Material. Es ist auch möglich, zwischen die Bauelemente und die Trägerfläche eine wärmeleitende Schicht, beispielsweise eine Grafitschicht, anzuordnen. Zur Kühlung der Bauelemente kann außerdem wenigstens ein Kühlmittelkanal innerhalb des Trägers vorhanden sein. Der Kühlmittelkanal kann an einen Kühlmittelkreislauf angeschlossen werden, so dass die von den elektrischen und/oder elektronischen Bauelementen abgegebene Wärme über das Kühlmittel abgeführt werden kann.

Die Verbindungseinrichtung zur Herstellung der Verbindung zwischen dem wenigstens einen Abdeckkörper und dem wenigstens einen Träger kann auf viele verschiedene Arten ausgeführt sein. Die Verbindung kann durch eine Rastverbindung, eine Steckverbindung, eine Schraubverbindung, eine Nietverbindung und optional zusätzlich durch eine stoffschlüssige Klebeverbindung hergestellt werden. Bei einem bevorzugten Ausführungsbeispiel ist die Verbindungseinrichtung zur Herstellung einer werkzeuglosen, lösbaren formschlüssigen und/oder kraftschlüssigen Verbindung eingerichtet. Hierfür weist die Verbindungseinrichtung wenigstens ein Rastmittel oder Steckmittel an jedem Abdeckkörper und/oder an jedem Träger auf. Jedem Rastmittel oder Steckmittel ist jeweils ein Gegenrastmittel oder Gegensteckmittel am entsprechend anderen Teil, also am Träger oder am Abdeckkörper zugeordnet. Bei hergestellter Verbindung arbeiten das Rastmittel und das Gegenrastmittel bzw. das Steckmittel und das Gegensteckmittel zwischen dem betreffenden Abdeckkörper und dem zugeordneten Träger zusammen.

Zur Verbesserung der Schutzart (IP-Schutz) gemäß EN 60529 kann eine Dichtungsanordnung zwischen dem wenigstens einen Abdeckkörper und dem wenigstens einen Träger angeordnet sein. Beispielsweise kann die Dichtungsanordnung eine um alle Aufnahmekammern eines Abdeckkörpers herum ringförmig geschlossen verlaufende Dichtung aufweisen. Die Dichtungsanordnung kann in einer Dichtungsnut am Abdeckkörper und/oder am Träger angeordnet sein.

Bei einer vorteilhaften Ausführung der Erfindung ist eine Kopplungseinrichtung vorhanden. Wenigstens einer der Abdeckkörper und/oder einer der Träger weist dabei ein Kopplungsmittel und/oder ein Gegenkopplungsmittel auf. Das Kopplungsmittel und ein zugeordnetes Gegenkopplungsmittel arbeiten zur Herstellung einer vorzugsweise lösbaren Verbindung zusammen. Auf diese Weise können zwei Abdeckkörper und/oder Träger über die Kopplungseinrichtung lösbar miteinander verbunden werden, so dass sich ein modulartiger Aufbau der Anordnung realisieren lässt. Es können somit zwei Abdeckkörper und/oder Träger formschlüssig und/oder kraftschlüssig vorzugsweise werkzeuglos und insbesondere lösbar über die Kopplungseinrichtung miteinander verbunden werden. Das Kopplungsmittel und das Gegenkopplungsmittel können auch elektrische Kontaktmittel bzw. elektrische Gegenkontaktmittel aufweisen, so dass gleichzeitig auch eine elektrische Verbindung zwischen zwei über die Kopplungseinrichtung miteinander verbundene Abdeckkörper und/oder Träger hergestellt ist.

Jeweils mindestens ein Träger mit den elektrischen und/oder elektronischen Bauelementen und mindestens ein Abdeckkörper können ein Modul bilden. Vorzugsweise weist jedes Modul zumindest ein Kopplungsmittel und/oder zumindest ein Gegenkopplungsmittel auf. Dadurch lassen sich mehrere Module in einer Raumrichtung oder auch in zwei Raumrichtungen miteinander Koppeln. Die Anordnung lässt sich dadurch flexibel modular aufbauen. Wenn die Module zum Beispiel Halbleiterleuchtmittel wie Leuchtdioden aufweisen, kann sehr einfach eine modular aufgebaute explosionsgeschützte Leuchte im Prinzip mit beliebiger Länge und/oder Fläche aufgebaut werden.

Das explosionsgeschützte Modul lässt sich über die Verbindungseinrichtung sehr einfach montieren. Über die Kopplungseinrichtung können einzelne Module schnell und einfach miteinander kombiniert werden. Es können auch Module mit unterschiedlichen Funktionen zu einer Einheit verbunden werden. Beispielsweise kann ein Modul mit Licht empfangenden Bauelementen als Bewegungsmelder dienen und Leuchtmittel anderer Module ein- und/oder ausschalten..

Wenn auf einem zugeordneten Träger bzw. wenn ein Modul Licht empfangende und/oder Licht abstrahlende Bauelemente aufweist, kann der wenigstens eine Abdeckkörper für jede Aufnahmekammer und mithin für jedes Licht empfangende und/oder Licht abstrahlende Bauelement ein optisches Element aufweisen. Das optische Element dient zum Lenken, Fokussieren, Streuen, Brechen oder dergleichen des vom zugeordneten Bauelement abgestrahlten oder in die Aufnahmekammer einfallenden, zu empfangenden Lichts. Ein solches optisches Element ist vorzugsweise durchlässig für die vom Bauelement abgestrahlte oder zu empfangende Lichtwellenlänge.

Beispielsweise kann es sich bei dem optischen Element um eine Linse handeln. Das optische Element kann in den Abdeckkörper integriert oder auf der dem Träger abgewandten Oberseite des Abdeckkörpers angeordnet sein. Ein optisches Element kann somit beispielsweise eine Sammellinse oder Zerstreuungslinse bilden. In den Abdeckkörper können alternativ oder zusätzlich auch eine Vielzahl von transparenten und/oder nicht-transparenten Partikeln zur Zerstreuung, Brechung, Reflexion oder Ablenkung des Lichts integriert werden. Über die Gestalt und die Dimensionierung der Abdeckplatte und/oder der optional vorhandenen optischen Elemente lässt sich auch die Strahldichte des von Leuchtdioden oder anderen Licht abstrahlenden Bauelementen abgestrahlten Lichts beeinflussen, insbesondere um die Anforderungen des Explosionsschutzes an die Strahldichte zu erfüllen.

Vorteilhafte Ausgestaltungen der Erfindung ergeben sich aus den abhängigen Patentansprüchen und der Beschreibung. Die Beschreibung beschränkt sich auf wesentliche Merkmale der Erfindung. Die Zeichnung ist ergänzend heranzuziehen. Nachfolgend werden bevorzugte Ausführungsbeispiele der Erfindung anhand der beigefügten Zeichnung näher erläutert. Es zeigen:
Figur 1 eine schematische Draufsicht auf ein Ausführungsbeispiel einer explosionsgeschützten Anordnung mit elektrischen und/oder elektronischen Bauelementen,
Figur 2 das Ausführungsbeispiel der Anordnung nach Figur 1 in einem schematischen Schnittbild gemäß der Schnittlinie II-II in Figur 1,
Figur 3 das Ausführungsbeispiel der Anordnung aus Figur 2 in einer Explosionsdarstellung im schematischen Schnittbild,
Figur 4 eine Detaildarstellung das Ausführungsbeispiels der Anordnung gemäß der Figuren 1 bis 3 in einem schematischen Schnittbild,
Figuren 5 und 6 jeweils ein Ausführungsbeispiel eines bzw. mehrerer Module der Anordnung in schematischer Seitenansicht und
Figur 7 ein Ausführungsbeispiel einer Kopplungseinrichtung zur Verbindung von Modulen der Anordnung in schematischer Draufsicht auf die Abdeckkörper.

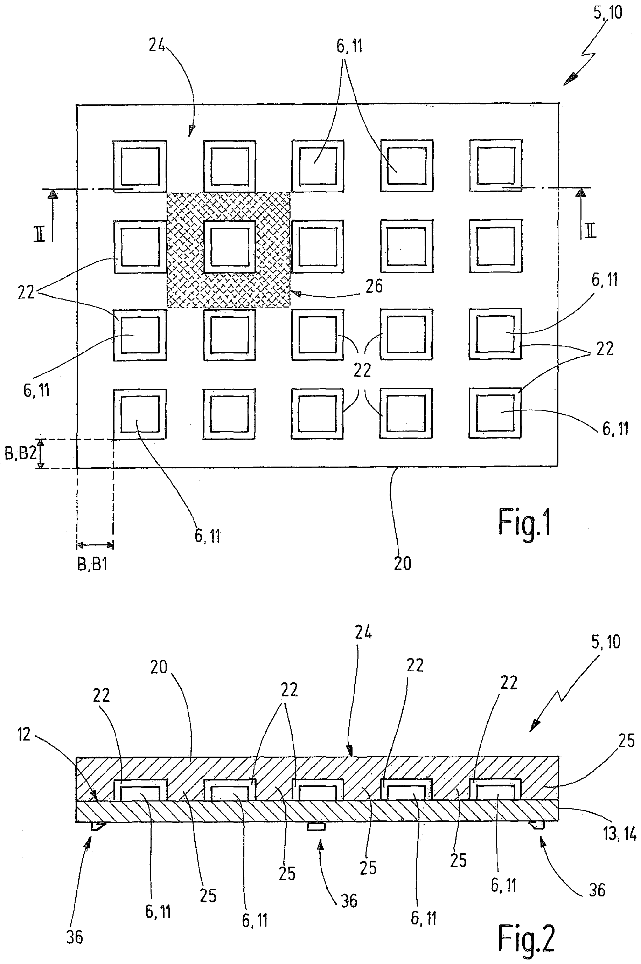

In den Figuren 1 bis 4 ist schematisch ein Ausführungsbeispiel einer explosionsgeschützten Anordnung 5 mit mehreren elektrische und/oder elektronischen Bauelementen 6 veranschaulicht. Die Bauelemente 6 können verschiedenster Art sein. Insbesondere kann es sich um Halbleiterbauelemente und/oder um Licht abstrahlende Bauelemente und/oder um Licht empfangende Bauelemente handeln. Bei den nachfolgend beschriebenen Ausführungsbeispielen ist die Anordnung 5 als Leuchtmittelanordnung 10 ausgeführt. Die elektrischen und/oder elektronischen Bauelemente 6 sind dabei durch Halbleiterleuchtmittel und beispielsgemäß durch Leuchtdioden 11 gebildet. Die erfindungsgemäße Anordnung 5 kann zusätzlich oder alternativ auch beliebige andere Bauelemente 6 aufweisen.

Die Leuchtmittelanordnung 10 weist eine Mehrzahl von Halbleiterleuchtmitteln auf, die beim Ausführungsbeispiel von Leuchtdioden 11 gebildet sind. Anstelle von Leuchtdioden 11 könnten auch andere Halbleiterleuchtmittel, wie etwa Lumineszenzdioden verwendet werden.

Die beispielsgemäß als Leuchtdioden 11 ausgeführten Bauelemente 6 sind mit Abstand zueinander auf einer Trägerfläche 12 eines Trägers 13 angeordnet. Die Trägerfläche 12 ist beispielsgemäß eben und erstreckt sich in einer Ebene. Auf der Trägerfläche 12 können neben den Leuchtdioden 11 auch Leiterbahnen, elektrische Verbindungsleitungen oder dergleichen angeordnet sein. Die elektrische Kontaktierung der Leuchtdioden 11 ist in den Figuren nicht näher dargestellt. Sie kann über Leiterbahnen und/oder Bonddrähte oder dergleichen erfolgen. Wenn der Träger 13 aus einem elektrisch leitfähigen Material besteht, kann eine elektrisch isolierende Isolationsschicht zumindest teilweise auf der Trägerfläche 12 vorhanden sein, um elektrische Kurzschlüsse zu vermeiden.

Wie erläutert können alternativ oder zusätzlich zu den Leuchtdioden 11 auch weitere elektrische und/oder elektronische Bauelemente 6 auf dem Träger 13 mechanisch befestigt und elektrisch kontaktiert sein.

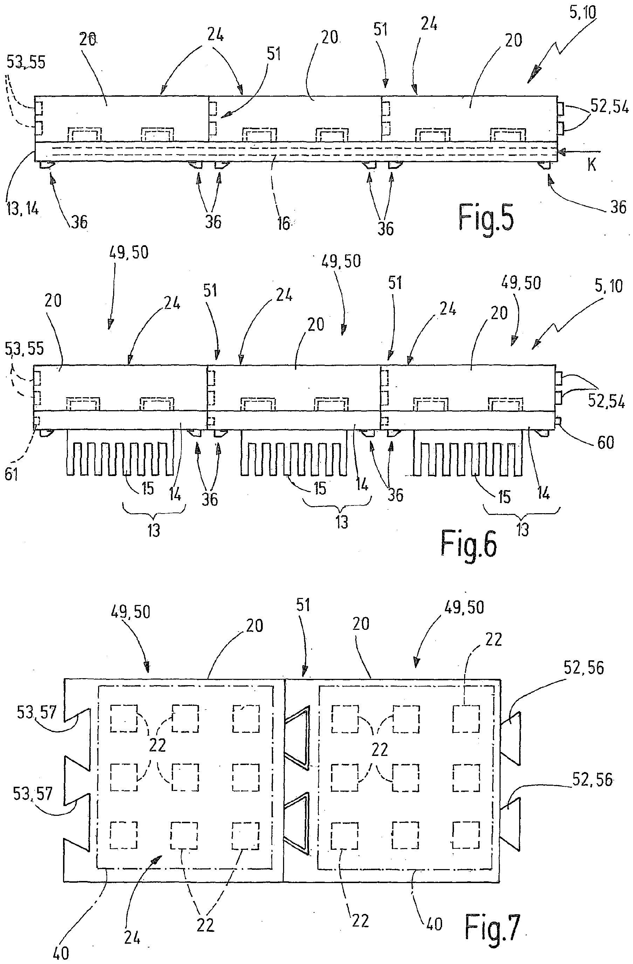

Bei den Ausführungsbeispielen der Anordnung 5 bzw. Leuchtmittelanordnung 10 gemäß der Figuren 1 bis 5 ist der Träger 13 durch eine Leiterplatte 14 gebildet. Alternativ hierzu kann der Träger 13 auch von einem Kühlkörper 15 gebildet sein, an dem unmittelbar die Trägerfläche 12 vorhanden ist. Es ist auch möglich, dass der Träger 13 aus einer Kombination von Leiterplatte 14 und Kühlkörper 15 gebildet ist, was beispielhaft in Figur 6 veranschaulicht ist.

Abhängig von der Ausführung des Trägers 13 kann dieser aus unterschiedlichen Materialien hergestellt sein. Vorzugsweise besteht der Träger 13 aus einem gut wärmeleitenden, beispielsweise metallischen Material, insbesondere Aluminium, oder er weist eine Aluminiumschicht oder einen Aluminiumkern auf. Zusätzlich oder alternativ können auch wärmeleitende Schichten, beispielsweise Grafit aufweisende Schichten, am Träger 13 vorhanden sein.

Bei dem in Figur 5 veranschaulichten Ausführungsbeispiel ist im Träger 13, beispielsgemäß in der Leiterplatte 14, ein Kühlmittelkanal 16 vorhanden, der lediglich schematisch veranschaulicht ist. Der Kühlmittelkanal 16 kann mäandrierend bzw. in Bögen oder Schleifen oder dergleichen durch die Leiterplatte 14 verlaufen. Er ist an zumindest einer Stelle an einen Kühlmittelkreislauf anschließbar, so dass Kühlmittel K durch den Kühlmittelkanal 16 zirkulieren kann, was schematisch in Figur 5 durch den Pfeil veranschaulicht ist.

Zu der beispielsgemäß von der Leuchtmittelanordnung 10 gebildeten Anordnung 5 gehört ferner ein Abdeckkörper 20. Im Abdeckkörper 20 sind auf einer der Trägerfläche 12 zugeordneten Unterseite 21 mehrere konkave Vertiefungen gebildet, die jeweils eine Aufnahmekammer 22 darstellen. Jede Aufnahmekammer 22 ist über eine einzige Öffnung 23 an der Unterseite 21 des Abdeckkörpers 20 offen und ansonsten ringsum durch den Abdeckkörper 20 geschlossen. Die der Unterseite 21 entgegengesetzte Oberseite 24 des Abdeckkörpers 20 stellt beispielsgemäß die Lichtabstrahlseite bzw. Lichtabstrahlfläche der Leuchtmittelanordnung 10 dar. Der Abdeckkörper 20 kann teilweise oder vollständig aus für die Lichtwellenlänge des von den Halbleiterleuchtmitteln abgestrahlten Lichts durchlässigem Material hergestellt sein. Diese Durchlässigkeit für Licht zumindest im Bereich einer Aufnahmekammer 22 ist dann vorhanden, wenn in der betreffenden Aufnahmekammer 22 ein Licht abstrahlendes Bauelement (hier: Leuchtdiode 11) und/oder ein Licht empfangendes Bauelement angeordnet ist. Für andere Anwendungen kann der Abdeckkörper 20 auch lichtundurchlässig sein.

Ringsumlaufend um die Öffnung 23 jeder Aufnahmekammer 22 ist am Abdeckkörper 20 ein Steg 25 gebildet. Jeder Steg 25 hat eine Stegfläche 26. Die Stegfläche 26 ist der Trägerfläche 12 des Trägers 13 zugeordnet. Die Stegflächen 26 der Stege 25 eines Abdeckkörpers 20 sind vorzugsweise eben und erstrecken sich in einer gemeinsamen Ebene. In Figur 1 ist lediglich schematisch beispielhaft die Stegfläche 26 für einen der Stege 25 punktiert veranschaulicht, der die zugehörige Aufnahmekammer 22 ringförmig umschließt. Der Stegabschnitt zwischen zwei unmittelbar benachbarten Aufnahmekammern 22 ist somit Bestandteil sowohl des Steges 25 um die eine Aufnahmekammer 22, als auch des Steges 25 um die unmittelbar benachbarte Aufnahmekammer 22.

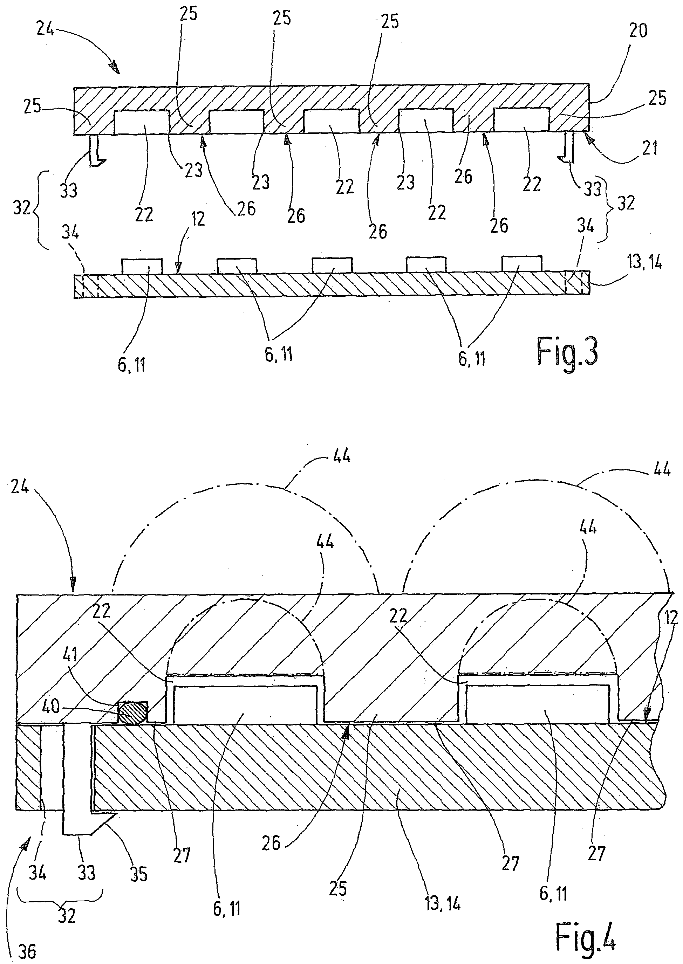

In Figur 1 ist außerdem die Breite B eines Steges 25 bzw. der Stegfläche 26 an einer Stelle beispielhaft eingezeichnet. Die Breite B kann an unterschiedlichen Abschnitten eines Steges 25 unterschiedliche Dimensionen B1, B2 aufweisen. Wichtig ist, dass die Breite B an keiner Stelle kleiner ist als ein vorgegebener Mindestwert. Die Breite B bzw. der Mindestwert für die Breite B kann abhängig vom Gesamtvolumen einer Aufnahmekammer 22 und/oder von dem verbleibenden Teilvolumen zwischen einem Bauelement 6, beispielsweise einer Leuchtdiode 11, und der die Aufnahmekammer 22 begrenzenden Fläche des Abdeckkörpers 20 ermittelt werden. Diese Mindestbreite für den Steg 25 bzw. die Stegfläche 26 dient zur Bildung eines zünddurchschlagsicheren Spalts 27 zwischen dem Abdeckteil 20 und dem zugeordneten Träger 13 (Figur 4) bei hergestellter Verbindung zwischen dem Abdeckteil 20 und dem Träger 13.

Der zünddurchschlagsichere Spalte 27 ist somit durch die Stegfläche 26 eines ringsumlaufenden Steges 25 um eine Aufnahmekammer 22 herum und den zugeordneten Flächenabschnitt auf der Trägerfläche 12 des Trägers 13 gebildet, was schematisch in Figur 4 dargestellt ist. Somit kann durch Aufsetzen des Abdeckteils 20 auf den Träger 13 derart, dass beispielsgemäß jeweils ein Bauelement 6 bzw. eine Leuchtdiode 11 in einer Aufnahmekammer 22 angeordnet ist, auf einfache Weise eine explosionsgeschützte Anordnung 5 bzw. Leuchtmittelanordnung 10 erreicht werden. In einer Aufnahmekammer 22 können in Abwandlung zum Ausführungsbeispiel auch mehrere, insbesondere bis zu fünf oder zehn Bauelemente 5 angeordnet sein. Beispielsweise kann eine Leuchtdiode 11 mit der ihr unmittelbar zugeordneten Beschaltung durch einen Kondensator und/oder eine Diode in einer Aufnahmekammer 22 angeordnet sein.

Die Verbindung zwischen dem Abdeckkörper 20 und dem Träger 13 ist vorzugsweise als lösbare kraftschlüssige und/oder formschlüssige Verbindung ausgestaltet. Zusätzlich kann auch eine stoffschlüssige Verbindung zwischen dem Abdeckteil 20 und dem Träger 13 vorgesehen sein. Jede Aufnahmekammer 22 mit einem Bauelement 6 bzw. einer Leuchtdiode 11 ist über einen Zünddurchschlagsicheren Spalt 27 gegenüber der Umgebung und/oder gegenüber der benachbarten Aufnahmekammer(n) 22 explosionsgeschützt ausgeführt. Dabei kann auf eine stoffschlüssige Abdichtung der einzelnen Aufnahmekammern 22 gegenüber dem Träger 13 verzichtet werden. Es sind voneinander über Stege 25 und zünddurchschlagsichere Spalte 27 getrennte kleine Volumen in den Aufnahmekammern 22 gebildet, was das Erreichen des Explosionsschutzes stark vereinfacht.

Zur Herstellung der Verbindung zwischen dem Abdeckteil 20 und dem Träger 13 ist eine Verbindungseinrichtung 32 vorgesehen. Bei dem bevorzugten Ausführungsbeispiel dient die Verbindungseinrichtung 32 dazu, werkzeuglos eine lösbare Verbindung zwischen dem Abdeckkörper 20 und dem Träger 13 herzustellen. Hierfür weist die Verbindungseinrichtung 32 wenigstens ein Rastmittel 33 und ein mit dem Rastmittel zur Herstellung der Verbindung zusammenarbeitendes Gegenrastmittel 34 auf. Alternativ zu dem Rastmittel 33 und dem Gegenrastmittel 34 könnte auch ein Steckmittel und ein Gegensteckmittel vorhanden sein. Auch eine Kombination verschiedener Mittel zur Herstellung einer kraft- und/oder formschlüssigen Verbindung ist möglich.

Wie geschildert, sind beim dargestellten Ausführungsbeispiel ein Rastmittel 33 und ein Gegenrastmittel 34 vorhanden. Das oder die Rastmittel 33 können am Abdeckkörper 20 und/oder am Träger 13 angeordnet sein. Das jeweils einem Rastmittel 33 zugeordnete Gegenrastmittel 34 ist dann am jeweils anderen Teil, also am Träger 13 bzw. dem Abdeckkörper 20 angeordnet. Die Anzahl der Rastmittel 33 und Gegenrastmittel 34 kann variieren und hängt von der Form und der Dimensionierung des Abdeckkörpers 20 bzw. des Trägers 13 ab.

Bei den veranschaulichten Ausführungsbeispielen sind die Rastmittel 33 am Abdeckkörper 20 angeordnet. Sie sind beispielsweise als Rasthaken mit einer Rastnase 35 ausgeführt und können an den Abdeckkörper 20 angeformt sein. Die Rastmittel 33 können somit bereits beim Herstellen des Abdeckkörpers 20 durch Gießen oder Spritzgießen mit dem Abdeckkörper 20 verbunden oder als Teil des Abdeckkörpers 20 hergestellt werden.

Die Gegenrastmittel 34 sind von Durchbrechungen im Träger 13 und beispielsgemäß der Leiterplatte 14 gebildet. Bei hergestellter Verbindung zwischen dem Abdeckkörper 20 und dem Träger 13 durchgreift der das Rastmittel 33 bildende Rasthaken die das Gegenrastmittel 34 bildende Durchbrechung und hintergreift den Träger 13 mit der Rastnase 35 auf der der Trägerfläche 12 entgegengesetzten Seite (Figur 4).

In Figur 4 ist lediglich beispielhaft eine Rastverbindung an einer Stelle veranschaulicht. Die anderen Rastverbindungen können entsprechend ausgeführt sein. Die Anzahl und der Abstand zwischen den Verbindungsstellen 36 durch ein Rastmittel 33 oder ein Steckmittel und ein entsprechend zugeordnetes Gegenrastmittel 34 oder Gegensteckmittel variieren abhängig von der Größe und der Gestalt des Abdeckkörpers 20 und des Trägers 13. Die Anzahl der Verbindungsstellen 36 ist so gewählt, dass auch durch mechanische Belastungen oder thermische Verformungen der zünddurchschlagsichere Spalt 27 um jede Aufnahmekammer 22 erhalten bleibt.

Die Verbindungseinrichtung 32 sorgt mithin dafür, dass der Abdeckkörper 20 am Träger 13 gehalten und gesichert ist, so dass zwischen den Stegflächen 26 und dem jeweils gegenüberliegenden Abschnitt der Trägerfläche 12 der zünddurchschlagsichere Spalt 27 gebildet ist und erhalten bleibt. Somit lässt sich auf sehr einfache Weise eine explosionsgeschützte Anordnung bzw. Leuchtmittelanordnung 10 erreichen. Die Montage und Handhabung sind stark vereinfacht. Insbesondere bei einer lösbaren Verbindung durch die Verbindungseinrichtung 22 lässt sich die Anordnung 5 bzw. Leuchtmittelanordnung 10 außerdem sehr einfach warten und reparieren.

Zur Erzielung bzw. Verbesserung der Schutzart gemäß EN60529 kann zwischen dem Abdeckkörper 20 und dem Träger 13 eine Dichtungsanordnung 40 vorhanden sein. Bei dem hier dargestellten Ausführungsbeispiel weist die Dichtungsanordnung 40 eine ringförmig geschlossene Dichtung auf, die um alle im Abdeckkörper 20 vorhandenen Aufnahmekammern 22 bzw. Öffnungen 23 herum verläuft und damit das Eindringen von Partikeln, Staub oder Wasser vermindert oder verhindert. Die Dichtungsanordnung 40 ist stark vereinfacht in den Figuren 4 und 7 veranschaulicht. Die Dichtungsanordnung 40 kann in einer Dichtungsnut 41 am Abdeckkörper 20 und/oder am Träger 13 angeordnet sein.

In Figur 4 ist durch die strichpunktierten Linien ebenfalls eine mögliche Abwandlung der beschriebenen Ausführungsbeispiele illustriert. Diese Abwandlung kann für Anordnungen 5 verwendet werden, die Licht abstrahlende Bauelemente 6 und/oder um Licht empfangende Bauelemente 6 aufweisen, also z.B. für die hier beschriebenen Ausführungsformen der Leuchtmittelanordnung 10.

Im Abdeckkörper 20 integriert und/oder auf der Oberseite 24 des Abdeckkörpers 20 angeordnet, können ein oder mehrere optische Elemente 44 angeordnet bzw. ausgebildet sein. Vorzugsweise ist jeder Aufnahmekammer 22 und mithin jeder Leuchtdiode 11 ein optisches Element 44 zugeordnet. Solche optischen Elemente 44 können für die Lichtwellenlänge der Leuchtdiode 11 durchlässig ausgeführt sein und zur Bildung von Sammellinsen oder Streulinsen im oder am Abdeckkörper 20 dienen. Dadurch kann die Lichtverteilung verändert werden. Zusätzlich oder anstelle von Linsen, können die optischen Elemente 44 auch eine Vielzahl von Licht streuenden und/oder Licht reflektierenden und/oder Licht brechenden Partikeln aufweisen.

Über die Gestalt und die Dimensionierung der Abdeckplatte 24 bzw. der optional vorhandenen optischen Elemente 44 lässt sich die Strahldichte des von den Leuchtdioden 11 abgestrahlten Lichts einstellen. Die Strahldichte kann daher über die Gestaltung des Abdeckkörpers 20 und/oder der optional vorhandenen optischen Elemente 44 verändert werden, um den Vorschriften des Explosionsschutzes zu genügen.

Die Anordnung 5 bzw. die Leuchtmittelanordnung 10 kann in Modulbauweise aus mehreren und im Prinzip einer beliebigen Anzahl von Modulen 49 aufgebaut sein, die im vorliegenden Fall als Leuchtmodule 50 ausgeführt sind. Eine Verbindung mehrere Module 49 bzw. Leuchtmodule 50 ist beispielhaft in Figur 6 veranschaulicht. Dort sind drei miteinander verbundene Module 49 dargestellt. Ein Modul 49 weist wenigstens einen Abdeckkörper 20 und wenigstens einen Träger 13 mit den auf der Trägerfläche 12 angeordneten Bauelementen 6 auf. Zu einem Modul 49 können auch mehrere Abdeckkörper 20 gehören, denen ein gemeinsamer Träger 13 zugeordnet ist (Figur 5). Alternativ hierzu wäre es ebenfalls möglich, dass zu einem Modul 49 ein Abdeckkörper 20 gehört, dem mehrere Träger 13 zugeordnet sind. Vorzugsweise weist jedes Modul 49 bzw. Leuchtmodul 50 einen einzigen Abdeckkörper 20 und einen einzigen Träger 13 mit einer Leiterplatte 14 und/oder einem Kühlkörper 15 auf. Dieser Aufbau ist in Figur 6 gezeigt.

Zur Verbindung zweier Module 49 bzw. Leuchtmodule 50 miteinander ist beispielsgemäß eine Kopplungseinrichtung 51 vorgesehen. Die Kopplungseinrichtung 51 dient zur Herstellung einer kraftschlüssigen und/oder formschlüssigen Kopplung zwischen zwei unmittelbar benachbarten Modulen 49 bzw. Leuchtmodulen 50.. Die Kopplungseinrichtung 51 ist beispielsgemäß ausschließlich an den Abdeckkörpern 20 angeordnet, könnte alternativ oder zusätzlich auch an den Trägern 13 der zu verbindenden Module 49 bzw. Leuchtmodule 50 angeordnet sein.

Die Kopplungseinrichtung 51 ist beim bevorzugten Ausführungsbeispiel dazu vorgesehen, werkzeuglos eine lösbare Verbindung zwischen zwei Modulen 49 herzustellen. Hierfür weist die Kopplungseinrichtung vorzugsweise an jedem Abdeckkörper 20 und/oder Träger 13 ein Kopplungsmittel 52 und ein mit dem Kopplungsmittel 52 zusammenarbeitendes Gegenkopplungsmittel 53 auf. Jedem Kopplungsmittel 52 ist ein Gegenkopplungsmittel 53 zugeordnet, um eine formschlüssige und/oder kraftschlüssige Verbindung herzustellen. Bei dem dargestellten Ausführungsbeispiel gemäß der Figuren 5 und 6 sind die Kopplungsmittel 52 durch jeweils einen Steckvorsprung 54 gebildet, dem jeweils eine Steckausnehmung 55 zugeordnet ist, der das Gegenkopplungsmittel 53 darstellt. Somit kann eine kraftschlüssige Steckverbindung zwischen den Abdeckkörpern 20 bzw. den Modulen 49 hergestellt werden.

Wie in Figuren 5 und 6 schematisch dargestellt, sind die Kopplungsmittel 52 an der einen Seitenfläche und die Gegenkopplungsmittel 53 an der jeweils entgegengesetzten Seitenfläche eines Abdeckkörpers 20 vorhanden, so dass die Abdeckkörper 20 ähnlich wie Steckklötze miteinander verbunden werden können. Die Kopplungsmittel 52 bzw. Gegenkopplungsmittel 53 könnten auch an den beiden anderen Seitenflächen zusätzlich oder alternativ vorhanden sein, so dass nicht nur eine Aufreihung von Abdeckkörpern 20 in einer Richtung, sondern auch eine zweidimensionale flächige Kopplung in zwei Raumrichtungen möglich ist.

In Figur 7 ist eine alternative Ausgestaltungsmöglichkeit der Kopplungseinrichtung 51 veranschaulicht. Dabei wird zwischen den Kopplungsmitteln 52 und den Gegenkopplungsmitteln 53 eine formschlüssige Verbindung erzeugt. Zu diesem Zweck sind die Kopplungsmittel 52 jeweils durch einen sich erweiternden Vorsprung 56 gebildet. Angepasst an die Kontur des Vorsprungs 56 ist das jeweils zugeordnete Gegenkopplungsmittel 53 durch eine sich nach außen verjüngende Aussparung 57 gebildet. Der jeweilige Vorsprung 56 kann formschlüssig in die jeweils zugeordnete Aussparung 57 eingreifen und somit eine formschlüssige Verbindung herstellen, wie es in Figur 7 schematisch veranschaulicht ist.

Die Vorsprünge 56 und die Aussparungen 57 haben bei dem in Figur 7 veranschaulichten Beispiel eine schwalbenschwanzförmige Gestalt. Abweichend hiervon können auch andere hinterschnittene Ausgestaltungen verwendet werden, beispielsweise in Form von Vorsprüngen und Aussparungen, wie sie von Puzzleteilen bekannt sind.

Die Kopplungseinrichtung 51 kann zusätzlich auch eine elektrische Verbindung zwischen zwei gekoppelten Modulen 49 herstellen. Dafür können insbesondere am Träger 13 eines Moduls 49 elektrische Kontaktmittel 60 und/oder elektrische Gegenkontaktmittel 61 vorhanden sein, die beim Herstellen einer mechanischen Kopplung durch die Kopplungsmittel 52 und die Gegenkopplungsmittel 53 eine elektrische Verbindung zwischen den beiden gekoppelten Modulen 49 herstellen, was schematisch in Figur 6 veranschaulicht ist.

Alternativ zu der Darstellung in Figur 6 können die Kontaktmittel 60 auch an dem Kopplungsmittel 52 und die Gegenkontaktmittel 61 am Gegenkopplungsmittel vorhanden sein. Beispielsweise kann jeweils eine elektrische leitende Kontaktfläche als Kontaktmittel 60 an den Vorsprüngen 56 bzw. 54 und als Gegenkontaktmittel 61 an den Ausnehmungen 55 bzw. 57 vorhanden sein.

Die Erfindung betrifft eine explosionsgeschützte Anordnung 5, beispielsweise eine Leuchtmittelanordnung 10. Die Anordnung 5 kann aus mehreren Modulen 49 gebildet werden. Jedes Modul 49 weist zumindest ein Abdeckteil 20 und zumindest einen Träger 13 auf. Der Träger 13 hat eine Trägerfläche 12, auf der elektrische und/oder elektronische Bauelemente 6, beispielsweise Halbleiterleuchtmittel wie Leuchtdioden 11, angeordnet und elektrisch kontaktiert sind. Der Abdeckkörper 20 hat eine der Trägerfläche 12 zugeordnete Unterseite 21, in die mehrere Aufnahmekammern 22 eingebracht sind. Jede Aufnahmekammer 22 ist nur an der Unterseite 21 über eine Öffnung 23 offen und ansonsten durch den Abdeckkörper 20 verschlossen. Stege 25 mit Stegflächen 26 begrenzen die Öffnungen 23 bzw. Aufnahmekammern 22. Bei hergestellter Verbindung zwischen dem Abdeckkörper 20 und dem Träger 13 ist vorzugsweise jedes Bauelement 6 oder eine Baugruppe aus mehreren Bauelementen 6 von einem Steg 25 ringförmig umschlossen, wobei die Stegfläche 26 mit dem zugeordneten Abschnitt der Trägerfläche 12 einen zünddurchschlagsicheren Spalt 27 bildet.

### Bezugszeichenliste:

- 5: Anordnung
- 6: Bauelement

- 10: Leuchtmittelanordnung
- 11: Leuchtdiode
- 12: Trägerfläche
- 13: Träger
- 14: Leiterplatte
- 15: Kühlkörper
- 16: Kühlmittelkanal

- 20: Abdeckkörper
- 21: Unterseite des Abdeckkörpers
- 22: Aufnahmekammer
- 23: Öffnung
- 24: Oberseite des Abdeckkörpers
- 25: Steg
- 26: Stegfläche
- 27: zünddurchschlagsicheren Spalt

- 32: Verbindungseinrichtung
- 33: Rastmittel
- 34: Gegenrastmittel
- 35: Rastnase
- 36: Verbindungsstelle

- 40: Dichtungsanordnung
- 41: Dichtungsnut

- 44: optisches Element

- 49: Modul
- 50: Leuchtmodul
- 51: Kopplungseinrichtung
- 52: Kopplungsmittel
- 53: Gegenkopplungsmittel
- 54: Steckvorsprung
- 55: Steckausnehmung
- 56: Vorsprung
- 57: Aussparung

- 60: Kontaktmittel
- 61: Gegenkontaktmittel

- B: Breite des Steges
- B1, B2: Werte für die Breite B
- K: Kühlmittel

## Patentansprüche

1. Explosionsgeschützte Anordnung (5),
mit wenigstens einem Träger (13), der eine Trägerfläche (12) aufweist, auf der mehrere elektrische und/oder elektronische Bauelemente (6) mit Abstand zueinander angeordnet sind,
mit wenigstens einem Abdeckkörper (20),
mit einer am wenigstens einen Abdeckkörper (20) und/oder am wenigstens einen Träger (13) angeordneten Verbindungseinrichtung (32) zur Herstellung einer kraftschlüssigen und/oder formschlüssigen Verbindung zwischen dem wenigstens einen Abdeckkörper (20) und dem wenigstens einen Träger (13),
wobei der wenigstens eine Abdeckkörper (20) mehrere Aufnahmekammern (22) für zumindest einen Teil der Bauelemente (6) aufweist, wobei die Aufnahmekammern (22) nur an der der Trägerfläche (12) zugewandten Seite eine Öffnung (23) aufweisen,
wobei um die Öffnung (23) jeder Aufnahmekammer (22) ein ringsumlaufender Steg (25) mit einer Stegfläche (26) vorhanden ist, dadurch gegengezeichnet , dass die Stegfläche bei hergestellter Verbindung zwischen dem wenigstens einen Abdeckkörper (20) und dem wenigstens einen Träger (13) mit der Trägerfläche (12) einen zünddurchschlagsicheren Spalt (27) bildet.

2. Explosionsgeschützte Anordnung nach Anspruch 1,
**dadurch gekennzeichnet, dass** in jeder Aufnahmekammer (22) genau ein Bauelement (6) angeordnet ist.

3. Explosionsgeschützte Anordnung nach Anspruch 1 oder 2,
**dadurch gekennzeichnet, dass** jedes Bauelement (6) in einer der Aufnahmekammern (22) angeordnet ist.

4. Explosionsgeschützte Anordnung nach einem der vorhergehenden Ansprüche,
**dadurch gekennzeichnet, dass** die Breite (B) des Steges (25) abhängig vom Gesamtvolumen der Aufnahmekammer (22) und/oder vom verbleibenden Restvolumen zwischen dem Bauelement (6) und der zugeordneten Aufnahmekammer (22) vorgegeben ist.

5. Explosionsgeschützte Anordnung nach einem der vorhergehenden Ansprüche,
**dadurch gekennzeichnet, dass** der wenigstens eine Abdeckkörper (20) aus einem einheitlichen Material ohne Naht- und Fügestelle hergestellt ist.

6. Explosionsgeschützte Anordnung nach einem der vorhergehenden Ansprüche,
**dadurch gekennzeichnet, dass** der wenigstens eine Träger (13) von einer Leiterplatte (14) gebildet ist oder eine Leiterplatte (14) aufweist.

7. Explosionsgeschützte Anordnung nach einem der vorhergehenden Ansprüche,
**dadurch gekennzeichnet, dass** der wenigstens eine Träger (13) von einem Kühlkörper (15) gebildet ist oder einen Kühlkörper (15) aufweist.

8. Explosionsgeschützte Anordnung nach einem der vorhergehenden Ansprüche,
**dadurch gekennzeichnet, dass** der wenigstens eine Träger (13) aus Metall besteht.

9. Explosionsgeschützte Anordnung nach einem der vorhergehenden Ansprüche,
**dadurch gekennzeichnet, dass** der wenigstens eine Träger (13) wenigstens einen Kühlmittelkanal (16) aufweist.

10. Explosionsgeschützte Anordnung nach einem der vorhergehenden Ansprüche,
**dadurch gekennzeichnet, dass** die Verbindungseinrichtung (32) wenigstens ein Rastmittel (33) oder Steckmittel an jedem Abdeckkörper (30) und/oder an jedem Träger (13) aufweist, dem jeweils ein Gegenrastmittel (34) oder Gegensteckmittel an jedem Träger (13) beziehungsweise an jedem Abdeckkörper (20) zugeordnet ist.

11. Explosionsgeschützte Anordnung nach einem der vorhergehenden Ansprüche,
**dadurch gekennzeichnet, dass** zwischen dem wenigstens einen Abdeckkörper (20) und dem wenigstens einen Träger (13) eine Dichtungsanordnung (40) angeordnet ist.

12. Explosionsgeschützte Anordnung nach einem der vorhergehenden Ansprüche,
**dadurch gekennzeichnet, dass** zumindest ein Träger (13) mit den daran angeordneten elektrischen und/oder elektronischen Bauelementen (6) und zumindest ein Abdeckkörper (20) ein Modul (49) bilden.

13. Explosionsgeschützte Anordnung nach Anspruch 12,
**dadurch gekennzeichnet, dass** zwei Module (49) über eine Kopplungseinrichtung (51) verbindbar sind, wobei jedes Modul ein Kopplungsmittel (52) und/oder ein Gegenkopplungsmittel (53) der Kopplungseinrichtung (51) aufweist.

14. Explosionsgeschützte Anordnung nach Anspruch 13,
**dadurch gekennzeichnet, dass** wenigstens zwei Module (49) formschlüssig und/oder kraftschlüssig über die Kopplungseinrichtung (51) miteinander verbindbar sind.

15. Explosionsgeschützte Anordnung nach Anspruch 13 oder 14,
**dadurch gekennzeichnet, dass** das Kopplungsmittel (52) und/oder das Gegenkopplungsmittel (53) an dem Träger (13) und/oder dem Abdeckkörper (20) eines Moduls (49) angeordnet ist.

16. Explosionsgeschützte Anordnung nach einem der vorhergehenden Ansprüche,
**dadurch gekennzeichnet, dass** zumindest einige der Bauelemente (6) von Licht abstrahlenden Bauelementen (11) und/oder Licht empfangenden Bauelementen gebildet sind.

17. Explosionsgeschützte Anordnung nach Anspruch 16,
**dadurch gekennzeichnet, dass** der Abdeckkörper (20) zumindest teilweise für die Lichtwellenlänge durchlässig ist, die von Licht abstrahlenden Bauelementen (11) emittiert wird und/oder die in die Aufnahmekammer (22) zu den Licht empfangenden Bauelementen einfällt.

18. Explosionsgeschützte Anordnung nach Anspruch 16 oder 17,
**dadurch gekennzeichnet, dass** integriert in den Abdeckkörper (20) oder auf der dem Träger (13) entgegengesetzten Oberseite (24) des Abdeckkörpers (20) ein optisches Element (44) angeordnet ist.

## Claims

1. Explosion-protected arrangement (5),
with at least one carrier (13) having a carrier surface (12) on which several electrical and/or electronic components (6) are arranged spaced apart from each other,
with at least one covering body (20),
with a connecting device (32) arranged on the at least one covering body (20) and/or on the at least one carrier (13) to create a force-fit and/or form-fit connection between the at least one covering body (20) and the at least one carrier (13),
wherein the at least one covering body (20) comprises several receiving chambers (22) for at least some of the components (6), wherein the receiving chambers (22) have an opening (23) only on the side facing the carrier surface (12),
wherein an annular peripheral web (25) with a web face (26) is present around the opening (23) of each receiving chamber (22),
**characterised in that** when the connection is created between the at least one covering body (20) and the at least one carrier (13), the web face forms with the carrier face (12) a gap (27) which is secure against ignition breakthrough.

2. Explosion-protected arrangement according to claim 1, **characterised in that** precisely one component (6) is arranged in each receiving chamber (22).

3. Explosion-protected arrangement according to claim 1 or 2, **characterised in that** each component (6) is arranged in one of the receiving chambers (22).

4. Explosion-protected arrangement according to any of the preceding claims, **characterised in that** the width (B) of the web (25) is predefined depending on the total volume of the receiving chamber (22) and/or on the residual volume remaining between the component (6) and the assigned receiving chamber (22).

5. Explosion-protected arrangement according to any of the preceding claims, **characterised in that** the at least one covering body (20) is made of a homogeneous material with no seam or joining point.

6. Explosion-protected arrangement according to any of the preceding claims,
**characterised in that** the at least one carrier (13) is formed by a circuit board (14) or comprises a circuit board (14).

7. Explosion-protected arrangement according to any of the preceding claims,
**characterised in that** the at least one carrier (13) is formed by a cooling body (15) or comprises a cooling body (15).

8. Explosion-protected arrangement according to any of the preceding claims,
**characterised in that** the at least one carrier (13) consists of metal.

9. Explosion-protected arrangement according to any of the preceding claims,
**characterised in that** the at least one carrier (13) has at least one coolant channel (16).

10. Explosion-protected arrangement according to any of the preceding claims,
**characterised in that** the connecting device (32) has at least one catch means (33) or push-fit means on each covering body (20) and/or on each carrier (13), to which a counter-catch means (34) or counter-push-fit means on each carrier (13) or each covering body (20) is assigned.

11. Explosion-protected arrangement according to any of the preceding claims,
**characterised in that** a sealing arrangement (40) is arranged between the at least one covering body (20) and the at least one carrier (13).

12. Explosion-protected arrangement according to any of the preceding claims,
**characterised in that** at least one carrier (13) with the electrical and/or electronic components (6) arranged thereon, and at least one covering body (20), together form a module (49).

13. Explosion-protected arrangement according to claim 12, **characterised in that** two modules (49) can be connected via a coupling device (51), wherein each module comprises a coupling means (52) and/or a counter-coupling means (53) of the coupling device (51).

14. Explosion-protected arrangement according to claim 13, **characterised in that** at least two modules (49) can be connected together by form fit and/or by force fit via the coupling device (51).

15. Explosion-protected arrangement according to claim 13 or 14, **characterised in that** the coupling means (52) and/or the counter-coupling means (53) is/are arranged on the carrier (13) and/or on the covering body (20) of a module (49).

16. Explosion-protected arrangement according to any of the preceding claims,
**characterised in that** at least some of the components (6) are formed by light-emitting components (11) and/or by light-receiving components.

17. Explosion-protected arrangement according to claim 16, **characterised in that** the covering body (20) is at least partially permeable to the light wavelength which is emitted by the light-emitting components (11) and/or which meets the light-receiving components in the receiving chamber (22).

18. Explosion-protected arrangement according to claim 16 or 17, **characterised in that** an optical element (44) is arranged integrated in the covering body (20) or on the top side (24) of the covering body (20) opposite the carrier (13).

## Revendications

1. Dispositif antidéflagrant (5),
comprenant au moins un support (13) qui présente une surface de support (12) sur laquelle sont disposés plusieurs composants (6) électriques et/ou électroniques, à distance les uns des autres,
comprenant au moins un corps de recouvrement (20),
comprenant un dispositif de liaison (32), disposé sur le corps de recouvrement (20), au nombre d'au moins un, et/ou sur le support (13), au nombre d'au moins un, et destiné à établir une liaison par adhérence et/ou par complémentarité de formes entre le corps de recouvrement (20), au nombre d'au moins un, et le support (13), au nombre d'au moins un,
le corps de recouvrement (20), au nombre d'au moins un, présentant plusieurs chambres de réception (22) pour au moins une partie des composants (6), les chambres de réception (22) présentant une ouverture ((23) uniquement sur la face tournée vers la surface de support (12),
sachant qu'il est prévu, autour de l'ouverture (23) de chaque chambre de réception (22), une nervure (25) périphérique dotée d'une surface de nervure (26), **caractérisé en ce que**, lorsque la liaison entre le corps de recouvrement (20), au nombre d'au moins un, et le support (13), au nombre d'au moins un, est établie, la surface de nervure forme un joint antidéflagrant (27) avec la surface de support (12).

2. Dispositif antidéflagrant selon la revendication 1, **caractérisé en ce qu'**exactement un composant (6) est disposé dans chaque chambre de réception (22).

3. Dispositif antidéflagrant selon la revendication 1 ou 2, **caractérisé en ce que** chaque composant (6) est disposé dans l'une des chambres de réception (22).

4. Dispositif antidéflagrant selon l'une des revendications précédentes, **caractérisé en ce que** la largeur (B) de la nervure (25) est prédéterminée en fonction du volume total de la chambre de réception (22) et/ou du volume résiduel subsistant entre le composant (6) et la chambre de réception (22) associée.

5. Dispositif antidéflagrant selon l'une des revendications précédentes, **caractérisé en ce que** le corps de recouvrement (20), au nombre d'au moins un, est réalisé à partir d'un matériau uniforme, sans soudure ni jonction.

6. Dispositif antidéflagrant selon l'une des revendications précédentes, **caractérisé en ce que** le support (13), au nombre d'au moins un, est constitué d'une carte de circuit imprimé (14) ou présente une carte de circuit imprimé (14).

7. Dispositif antidéflagrant selon l'une des revendications précédentes, **caractérisé en ce que** le support (13), au nombre d'au moins un, est constitué d'un corps de refroidissement (15) ou présente un corps de refroidissement (15).

8. Dispositif antidéflagrant selon l'une des revendications précédentes, **caractérisé en ce que** le support (13), au nombre d'au moins un, est en métal.

9. Dispositif antidéflagrant selon l'une des revendications précédentes, **caractérisé en ce que** le support (13), au nombre d'au moins un, présente au moins un canal de fluide de refroidissement (16).

10. Dispositif antidéflagrant selon l'une des revendications précédentes, **caractérisé en ce que** le dispositif de liaison (32) présente au moins un moyen d'encliquetage (33) ou un moyen d'enfichage sur chaque corps de recouvrement (30) et/ou sur chaque support (13), auquel est associé respectivement un moyen d'encliquetage conjugué (34) ou un moyen d'enfichage conjugué sur chaque support (13), respectivement sur chaque corps de recouvrement (20).

11. Dispositif antidéflagrant selon l'une des revendications précédentes, **caractérisé en ce qu'**un dispositif d'étanchéité (40) est placé entre le corps de recouvrement (20), au nombre d'au moins un, et le support (13), au nombre d'au moins un.

12. Dispositif antidéflagrant selon l'une des revendications précédentes, **caractérisé en ce qu'**au moins un support (13), avec les composants (6) électriques ou électroniques disposés sur celui-ci, et au moins un corps de recouvrement (20) forment un module (49).

13. Dispositif antidéflagrant selon la revendication 12, **caractérisé en ce que** deux modules (49) peuvent être reliés par l'intermédiaire d'un dispositif d'accouplement (51), chaque module présentant un moyen d'accouplement (52) et/ou un moyen d'accouplement conjugué (53) du dispositif d'accouplement (51).

14. Dispositif antidéflagrant selon la revendication 13, **caractérisé en ce qu'**au moins deux modules (49) peuvent être reliés entre eux par complémentarité de formes et/ou par adhérence par le dispositif d'accouplement (51).

15. Dispositif antidéflagrant selon la revendication 13 ou 14, **caractérisé en ce que** le moyen d'accouplement (52) et/ou le moyen d'accouplement conjugué (53) est disposé sur le support (13) et/ou le corps de recouvrement (20) d'un module (49).

16. Dispositif antidéflagrant selon l'une des revendications précédentes, **caractérisé en ce qu'**au moins quelques-uns des composants (6) sont constitués de composants (11) émettant de la lumière et/ou de composants recevant de la lumière.

17. Dispositif antidéflagrant selon la revendication 16, **caractérisé en ce que** le corps de recouvrement (20) est transparent au moins en partie à la longueur d'onde lumineuse qui est émise par des composants (11) émettant de la lumière et/ou qui est incidente dans la chambre de réception (22) menant aux composants recevant de la lumière.

18. Dispositif antidéflagrant selon la revendication 16 ou 17, **caractérisé en ce qu'**un élément optique (44) est disposé en étant intégré dans le corps de recouvrement (20) ou sur la face supérieure (24) du corps de recouvrement (20) opposée au support (13).
